# EUROPÄISCHE PATENTSCHRIFT

(11) **EP 3 502 542 B1**
(45) Veröffentlichungstag und Bekanntmachung des Hinweises auf die Patenterteilung: **18.06.2025**
(21) Anmeldenummer: 18152566.8
(22) Anmeldetag: 19.01.2018
(51) Int. Cl.: F21K 9/27, F21V 23/00, F21Y 103/10, F21Y 115/10

(54) **RÖHRENLAMPE MIT LEADFRAME**
TUBULAR LAMP WITH LEADFRAME
LAMPE TUBULAIRE POURVUE D'UNE GRILLE DE CONNEXION

(30) Priorität: 22.12.2017 DE 102017131063
(43) Veröffentlichungstag der Anmeldung: 26.06.2019
(73) Patentinhaber: Ledvance GmbH, 85748 Garching bei München (DE)
(72) Erfinder: RIEDER, Bernhard, 93049 Regensburg (DE); ROSENBAUER, Georg, 91717 Wassertrüdingen (DE)
(74) Vertreter: Lanchava, Bakuri

(56) Entgegenhaltungen:
- EP-A1- 2 831 493
- EP-B1- 2 831 493
- WO-A1-02/089222
- WO-A1-2012/007899
- WO-A1-2013/175713
- DE-A1- 102014 214 603
- US-A1- 2004 252 501
- US-A1- 2010 164 409
- US-A1- 2013 135 850
- US-A1- 2014 029 249
- US-A1- 2014 268 779
- US-A1- 2014 313 713
- US-A1- 2015 276 140
- US-A1- 2016 081 147
- US-A1- 2016 255 694

## Beschreibung

### Technisches Gebiet

Die vorliegende Erfindung betrifft eine Röhrenlampe mit einer auf einem Leadframe basierenden Light Engine, insbesondere eine LED-Retrofit-Röhrenlampe, z.B. der Bauformen T5 und T8.

### Stand der Technik

Leuchtstoff-Röhrenlampen werden mehr und mehr durch Retrofit-Röhrenlampen mit Halbleiterleuchtelementen (z.B. Leuchtdioden, LEDs) ersetzt. Derartige Retrofit-Röhrenlampen weisen für gewöhnlich ein Gehäuse in Form eines röhrenförmigen Kolbens, der zumindest teilweise lichtdurchlässig (transluzent oder transparent) ist, mit zwei Endkappen an den beiden Enden des röhrenförmigen Kolbens, eine Light Engine, die eine Mehrzahl von LEDs beinhaltet, und einen elektronischen Treiber, der die LEDs mit elektrischer Energie mit den erforderlichen elektrischen Parametern (Strom, Spannung) zu deren Betrieb versorgt, auf.

Der Begriff "Light Engine" wird üblicherweise verwendet für die Anordnung aus der Mehrzahl der LEDs und einer Haltestruktur für die LEDs, welche elektrisch leitfähige Strukturen und/oder Kabel beinhaltet, über die die LEDs mit elektrischer Energie vom elektrischen Treiber versorgt werden können.

Viele Retrofit-LED-Röhrenlampen verwenden für die Light Engine eine Leiterplatte, auf der die LEDs befestigt, beispielsweise aufgelötet, sind. Solche Leiterplattenwerden üblicherweise durch Ätzen eines Rohlings, der eine auf einem elektrisch nichtleitenden Substrat angeordnete Kupferschicht aufweist, hergestellt. Dies sorgt für einen großen Verbrauch an Kupfer und entsprechend für hohe Herstellungskosten und eine starke Umweltbelastung.

Aus der deutschen Patentanmeldung DE 10 2017 109 853.4 ist bekannt, die Light Engine einer Retrofit-Röhrenlampe auf einem sogenannten Wiring Board aufzubauen. Wiring Boards bestehen aus Streifen eines elektrisch leitenden Materials (z.B. Aluminium), das zwischen elektrisch isolierenden, flexiblen Schichten (z.B. Polyimid) laminiert ist. Durch Ausstanzen von Teilen der elektrisch leitenden Streifen kann dann das gewünschte Schaltungsdesign erzielt werden. Durch Öffnungen in einer der elektrisch isolierenden Schichten können die LEDs mit den elektrisch leitenden Streifen verbunden werden.

Auch die Herstellung von Wiring Boards ist bei allen Vorteilen gegenüber Leiterplatten aufwändig und teuer.

Aus US2014268779A1, WO 2013/144858 A1, US 2004/0252501 A1, US 2016/0255694 A1 und US 2015/0276140 A1 sind Leuchtmittel bekannt, bei denen die Haltestruktur für die LEDs einen Leadframe aufweist.

### Darstellung der Erfindung

Ausgehend von dem bekannten Stand der Technik ist es eine Aufgabe der vorliegenden Erfindung, ein Leuchtmittel mit einer vereinfachten Light Engine bereitzustellen.

Die Aufgabe wird durch eine Leuchtvorrichtung mit den Merkmalen des unabhängigen Anspruchs gelöst. Vorteilhafte Weiterbildungen ergeben sich aus den Unteransprüchen.

Entsprechend wird ein Leuchtmittel mit einem lichtdurchlässigen röhrenförmigen Kolben, mindestens einer an einem Ende des röhrenförmigen Kolbens angeordneten Endkappe und einer im röhrenförmigen Kolben angeordneten Light Engine vorgeschlagen. Erfindungsgemäß weist die Light Engine einen Leadframe auf, auf dem eine Mehrzahl von Halbleiterleuchtelementen, insbesondere LEDs, angeordnet ist, wobei der Leadframe mindestens drei zueinander parallele Bahnen aufweist, wobei mindestens zwei der Bahnen mehrere Abschnitte aufweisen, wobei die Abschnitte einer ersten Bahn versetzt zu den Abschnitten einer zweiten Bahn angeordnet sind, sodass diese jeweils über einen halben Abschnitt überlappen, wobei zumindest einige der Halbleiterelemente sowohl mit einem Abschnitt der ersten Bahn als auch mit einem Abschnitt der zweiten Bahn direkt verbunden sind und wobei eine dritte Bahn des Leadframes über die Länge des Leadframes durchgehend ist. Als Leadframes werden hier elektrisch leitende Strukturen bezeichnet, die aus einem Metallblech gestanzt oder geschnitten (z.B. mittels Laserschneiden oder Wasserstrahlschneiden) werden und ohne elektrisch isolierendes Substrat (wie Leiterplatten) oder elektrisch isolierende, flexiblen Schichten (wie Wiring Boards) auskommen. Zur Herstellung eines Leadframes werden die Leiterbahnen aus einem Blech ausgestanzt oder ausgeschnitten, wobei Transportstreifen und Verbindungsstege zur Stabilisierung des gestanzten Blechs für die Weiterverarbeitung verbleiben. Die Transportstreifen und Verbindungsstege werden zu einem späteren Zeitpunkt entfernt, z.B. wenn der Leadframe durch darauf befestigte elektrische Komponenten ausreichend stabilisiert ist.

Die Befestigung der Halbleiterleuchtelemente erfolgt durch eine SMD-Löttechnik (SMD steht für "Surface-mount device"), bei der die Lötpunkte auf den ausgestanzten Blechteilen (Leiterbahnen) mit einer Lötpaste versehen, anschließend mit den Halbleiterleuchtelementen bestückt und schließlich durch Infrarotstrahlung eines Schmelzofens erhitzt werden, wodurch die Lötpaste schmilzt. Auf diese Weise werden die Halbleiterleuchtelemente mit den Leiterbahnen verbunden.

Der Leadframe ist ein flächiges Gebilde, das zwei gegenüberliegende und im Wesentlichen parallel verlaufende Oberflächen im Abstand der Blechdicke aufweist. Der Leadframe kann beispielsweise aus einem kostengünstigen Material, wie etwa Stahl, oder einem Material mit hoher Wärmeleitfähigkeit, wie etwa Kupfer, oder einem optisch hochwertig erscheinenden Metall, wie etwa Messing, gefertigt sein. Die Blechdicke liegt vorzugsweise im Bereich von 0,1 mm bis 2 mm, noch bevorzugter im Bereich von 0,2 mm bis 0,8 mm. Insbesondere kommen Materialien in Frage, die für gedruckte Platinen (PCB) anwendbar sind. Zudem kann der Leadframe beschichtet sein, beispielsweise mit einer Sn-, Zn-, Au-, Ag-, Pt-, Pd- oder Ni-Schicht, und/oder die Oberflächen des Leadframes können teilweise oder vollständig aufgeraut sein. Die Oberflächen des Leadframes können auch mit einer gut reflektierenden Beschichtung, z.B. mit einer weißen oder hellen Farb- oder Lackschicht (insbesondere Lötstopplack) beschichtet sein.

Die Herstellung eines Leadframes ist somit einfacher als die eines Wiring Boards oder einer Leiterplatte. Auch können die leitenden Strukturen flexibler gewählt werden, als bei einem Wiring Board. Durch die Wärmeleitfähigkeit des metallischen Leadframes wird auch die Wärmeabfuhr von den Halbleiterleuchtelementen während des Betriebs verbessert.

Im Rahmen der vorliegenden Offenbarung bedeutet "auf dem Leadframe angeordnet", dass die entsprechende Komponente am Leadframe befestigt ist und in elektrischer Verbindung mit dem Leadframe steht.

Die Anordnung der Komponenten kann auf einer Oberfläche oder auf beiden Oberflächen des Leadframes erfolgen. Insbesondere bei den Halbleiterleuchtelementen kann durch eine beidseitige Bestückung des Leadframes eine bessere Rundumabstrahlung des Lichts erreicht werden.

In einer Ausführungsform weist das Leuchtmittel zwei Endkappen auf, die an gegenüberliegenden Enden des röhrenförmigen Kolbens angeordnet sind. Ein solches Leuchtmittel kann beispielsweise die Bauform T5 oder T8 aufweisen.

In einer Ausführungsform weist das Leuchtmittel genau eine Endkappe auf, die an einem Ende des röhrenförmigen Kolbens angeordnet ist. Das andere Ende des röhrenförmigen Kolbens kann mit dem Material des röhrenförmigen Kolbens verschlossen sein. Ein solches Leuchtmittel kann beispielsweise als Retrofit-Lampe für eine Kompaktleuchtstofflampe ausgestaltet sein.

In einer Ausführungsform ist der röhrenförmige Kolben gasdicht verschlossen. Vorzugsweise ist der gasdichte röhrenförmige Kolben mit einem Füllgas gefüllt, das insbesondere ein Gas mit hoher Wärmeleitfähigkeit aufweist. Das Gas mit hoher Wärmeleitfähigkeit kann beispielsweise Helium, Sauerstoff oder Wasserstoff oder eine Mischung aus diesen (z.B. Helium/Wasserstoff oder Helium/Sauerstoff) sein. Durch eine Füllung des röhrenförmigen Kolbens mit einem Gas mit hoher Wärmeleitfähigkeit kann die Abfuhr von Wärme von den Halbleiterleuchtelementen während des Betriebs weiter verbessert werden.

Das Füllgas kann weitere gasförmige Bestandteile aufweisen, mit denen beispielsweise hohe Gefäßinnendrucke und/oder optische Lichtveränderungen, wie Lichtfilterungen und verbesserte Lichtleistungen erreicht werden. Beispielsweise kann das Füllgas auch Stickstoff, Argon, Luft, Neon, Kohlendioxid, Stickstoffdioxid oder Schwefelhexafluorid aufweisen.

Vorteilhafter Weise beträgt der Anteil des Gases mit hoher Wärmeleitfähigkeit am Füllgas 1 - 100%, bevorzugt 50 - 90%.

Der Gasdruck im Gefäß beträgt in der Praxis zwischen 0,01 und 1200 hPa, wobei ein bevorzugter Gasdruck zwischen 0,1 und 1000 hPa liegt.

In einer Ausführungsform weist das Leuchtmittel einen elektronischen Treiber mit mehreren elektronischen Bauteilen auf, wobei mindestens eines der elektronischen Bauteile innerhalb des röhrenförmigen Kolbens angeordnet ist. Es können eines, mehrere oder alle elektronischen Bauteile innerhalb des röhrenförmigen Kolbens angeordnet sein. Vorzugsweise sind insbesondere elektronische Bauteile, bei denen eine Ausgasung während des Betriebs zu erwarten ist, außerhalb des röhrenförmigen Kolbens angeordnet sein. Damit wird verhindert, dass die Ausgasungen das im röhrenförmigen Kolben vorhandene Füllgas und damit möglicherweise dessen Eigenschaften verändern.

Es ist ein weiterer Vorteil der Verwendung eines Leadframes als Träger für die Halbleiterleuchtelemente, dass dadurch Ausgasungen durch den Träger (in bekannten Leuchtmitteln z.B. durch die Leiterplatte oder das Wiring Board) weitestgehend reduziert werden.

Es ist von Vorteil, möglichst viele elektrische Bauteile des elektronischen Treibers innerhalb des vorzugsweise gasdichten röhrenförmigen Kolbens anzuordnen. Dadurch werden die Komponenten des Leuchtmittels bestmöglich vor äußeren Einflüssen geschützt und das Leuchtmittel kann in Umgebungen mit anspruchsvollen Umweltbedingungen zum Einsatz kommen, z.B. als Straßenbeleuchtung, in Gewächshäusern, in Küstenregionen mit hohem Salzgehalt in der Luft, Produktionsumgebungen mit aggressiven Gasen, usw.

Je nach Einsatzumgebung können die Halbleiterleuchtelemente mit einem entsprechend geeigneten Spektralbereich gewählt werden. Dabei können alle Halbleiterleuchtelemente im Wesentlichen im gleichen Spektralbereich Licht emittieren oder es können zwei oder mehr verschiedene Typen von Halbleiterleuchtelementen zum Einsatz kommen, z.B. blau emittierende und rot emittierende Halbleiterleuchtelemente für die Beleuchtung von Pflanzen.

In einer Ausführungsform ist mindestens eines der innerhalb des röhrenförmigen Kolbens angeordneten elektronischen Bauteile auf dem Leadframe angeordnet. Dadurch kann der Leadframe für die elektrische Verbindung des elektronischen Bauteils sorgen. Eine Leiterplatte, auf der weitere elektronische Bauteile des elektronischen Treiber angeordnet sind, kann dadurch möglichst klein ausfallen. Dies verringert weiter mögliche Ausgasungen im Inneren des röhrenförmigen Kolbens durch die Leiterplatte.

In einer Ausführungsform weist der Leadframe einen Mittelbereich, auf dem die Mehrzahl von Halbleiterleuchtelementen angeordnet ist, und mindestens einen Endbereich, auf dem mindestens eines der elektronischen Bauteile des elektronischen Treibers angeordnet ist, auf. Dadurch können insbesondere die elektronischen Bauteile des elektronischen Treibers, die größer sind als die Halbleiterleuchtelemente an den Enden abseits der Halbleiterleuchtelemente angeordnet werden, wo sie die Abstrahlung von Licht durch die Halbleiterleuchtelemente möglichst wenig behindern.

Es können aber auch elektronische Bauteile des elektronischen Treibers im Mittelbereich des Leadframes angeordnet sein.

Wenn die elektronischen Bauteile des elektronischen Treibers in beiden Endbereichen des Leadframes angeordnet sind, kann der Leadframe zusätzliche Verbindungsabschnitte aufweisen, die die beiden Endbereiche elektrisch verbinden.

Um zu verhindern, dass derartige Verbindungsabschnitte, die sich über die gesamte Länge des Leadframes erstrecken, unerwünschte elektromagnetische Störausstrahlungen (*electromagnetic interference,* EMI) zur Folge haben, können diese Verbindungsabschnitte an einer oder mehreren Stellen über Kondensatoren mit benachbarten Abschnitten des Leadframes verbunden werden. Diese Vorgehensweise ist beispielsweise in der deutschen Patentanmeldung DE 10 2017 103 184.7 beschrieben.

In einer Ausführungsform ist die Breite des Leadframes in mindestens einem Endbereich größer ist als die Breite des Leadframes im Mittelbereich. Dadurch steht für den elektronischen Treiber ausreichend Platz zur Verfügung, während der Mittelbereich mit den Halbleiterleuchtelementen so schmal wie möglich ausgeführt werden kann. Es ist aus Gründen der Materialersparnis (Umwelt- und Kostenvorteile) von Vorteil, den Mittelbereich möglichst schmal auszuführen. Beispielsweise beträgt die Breite des Leadframes im Mittelbereich zwischen etwa 6 mm und etwa 10 mm, vorzugsweise zwischen etwa 7 mm und etwa 8 mm. Insbesondere wenn keine Verbindungsabschnitte für Teile des elektronischen Treiber in beiden Endbereichen des Leadframes benötigt werden, kann die Breite des Mittelbereichs etwa 7 mm betragen. Mit zusätzlichen Verbindungsabschnitten kann die Breite des Mittelbereichs bis zu etwa 10 mm erreichen.

In einer Ausführungsform ist die Breite des Leadframes über dessen Länge variabel ist. Insbesondere kann sich die Breite des Leadframes über dessen Länge linear, vorzugsweise kontinuierlich linear verändern, beispielsweise von einer ersten Breite an einem ersten Ende des Leadframes zu einer zweiten Breite, die geringer ist als die erste Breite, an einem zweiten Ende des Leadframes. Dadurch kann am breiteren Ende des Leadframes ausreichend Platz für den elektronischen Treiber zur Verfügungsgestellt werden.

Eine Ausführung des Leadframes mit sich kontinuierlich linear verändernder Breite hat ferner den Vorteil, dass mehrere Leadframes ohne Verschnitt aus einem Ausgangsmaterial gefertigt werden können, indem abwechselnd ein schmales und ein breites Ende benachbarter Leadframes nebeneinander angeordnet wird.

Eine Fertigung mehrerer Leadframes ohne Verschnitt aus einem Ausgangsmaterial kann auch erreicht werden, wenn nur einer der Endabschnitte des Leadframes breiter ist als der Mittelabschnitt, und zwar vorzugsweise ungefähr doppelt so breit wie der Mittelabschnitt. Dann können bei der Fertigung die breiten Endabschnitte des ersten, dritten, usw. Leadframes auf einer Seite nebeneinander angeordnet werden und die breiten Endabschnitte des zweiten, vierten, usw. Leadframes können auf der anderen Seite angeordnet werden, also die entsprechenden Leadframes um 180° gedreht werden.

In einer Ausführungsform ist der elektronische Treiber ein linearer Treiber. Lineare Treiber für LED-Lampen sind beispielsweise aus den internationalen Patentanmeldungen WO 2007/144365 A1 und WO 02/23956 A2 bekannt. Die in diesen Veröffentlichungen offenbarten linearen Treiber können auch in erfindungsgemäßen Ausführungsformen des Leuchtmittels verwendet werden.

Ein linearer Treiber hat den Vorteil, dass er mit sehr wenigen elektronischen Bauteilen auskommt. Kernstück des linearen Treibers ist ein Stromregler, der üblicherweise als integrierter Schaltkreis (IC) verfügbar ist. In den oben genannten Veröffentlichungen kommt als Stromregler ein Transistor bzw. ein LM317AT von National Semiconductor zum Einsatz. Als Alternative kann ein BP5151HC von Bright Power Semiconductor Co. verwendet werden.

Bei einem linearen Treiber muss insbesondere beim Stromregler auf eine gute Kühlung geachtet werden. Vorzugsweise ist daher insbesondere der Stromregler auf dem Leadboard angeordnet, wodurch die von diesem im Betrieb erzeugte Wärme gut abgeführt werden kann.

In einer Ausführungsform ist der elektronische Treiber in einem Füllmaterial eingebettet. Das Füllmaterial kann eine Polymermasse (z.B. Gießharze und/oder hochviskose Kleber aus Silikon, Polyurethan, Polyacryl, Polyester, Polyamid, Polyolefin und/oder Epoxid) und/oder einen Füllstoff (z.B. Glasperlen, Sand, Kalk, Keramik-Pulver wie z.B. Al₂O₃ oder eine Mischung aus diesen) aufweisen. Die Polymermasse kann transluzent (insbesondere transparent) sein. Der im Füllmaterial eingebettete Treiber kann ferner mit einer Versiegelungsschicht (z.B. Polymer) versehen sein. Die Polymermasse kann temperatur-, UV-, feuchtigkeits- und/oder zeitaushärtend sein.

Durch das Einbetten des elektronischen Treibers in ein solches Füllmaterial (Potten oder Potting) kann die Wärmeanbindung des elektronischen Treibers in den Glaskolben verbessert werden. Insbesondere kann die vom Stromregler und/oder vom Kondensator beim Betrieb erzeugte Wärme besser an die Wand des Glaskolbens und an die Endkappe abgeführt werden.

Ferner können durch das Potten des elektronischen Treibers mögliche Ausgasungen aus den elektronischen Bauteilen von der Light-Engine mit den Halbleiterleuchtelementen abgekapselt werden. Dies kann insbesondere bei als Glättungskondensatoren verwendeten Elektrolyt-Kondensatoren von Interesse sein.

Solche gepotteten elektronischen Treiber sind bevorzugt einseitig, d.h. nur in einer Endkappe) in der Lampe angeordnet, da der Füllvorgang an der einseitig geschlossenen Lampe über Schwerkraft erfolgen kann. Der elektronische Treiber kann dabei sowohl auf dem Leadframe positioniert sein, als auch auf einer separaten Leiterplatte.

Im Fall der separaten Leiterplatte kann der elektronische Treiber auch außerhalb der Lampe vorgepottet sein, um die elektronischen Bauteile zu umhüllen und etwaige Ausgasungen aus den elektronischen Bauteilen und der separaten FR4-Leiterplatte zu verringern. Unabhängig davon kann auch der vorgepottete Treiber mittels nachgeschaltetem weiterem Pottingrozess an den Glaskolben angebunden werden.

In einer weiteren Ausführungsform ist der Lampeninnenraum auch im Bereich der Halbleiterleuchtelemente mit einem transluzenten (insbesondere transparenten) Füllmaterial (z.B. Glasperlen, glitzernde Acryl-Strass-Steine mit Diamanteffekt, Polymergranulat oder eine Mischung daraus) gefüllt. Dadurch kann die Wärmeabfuhr verbessert werden und das optische Erscheinungsbild des Leuchtmittels beeinflusst werden. Eine solche Ausführungsform kann besonders hochwertig aussehen. Außerdem kann auf eine Beschlämmung oder Innenmattierung des Glaskolbens, die normalerweise vorgenommen wird, um das Lampeninnere von außen nicht sichtbar zu machen, verzichtet werden.

Um Gewicht und Füllmaterial zu sparen, kann eine Teilbeschichtung des Kolbens durch ein solches transluzentes Füllmaterial (optische Streupartikel) vorgenommen werden. Dabei kann der Kolben schrägt gestellt und mit einem Gemisch aus Gießharz/Kleber mit optischen Füllstoffen (Glasperlen, Keramikpulver, Acryl-Strass-Glitzer-Steine mit Diamanteffekt, etc.) gefüllt werden. Dabei läuft das niedrigviskose Gießharz-Füllstoff-Gemisch auf der zu den Halbleiterleuchtelementen gegenüberliegenden Seite (d.h. auf der Seite, zu der hin die Lichtemission erfolgt) nach unten. Die Lampe ist dabei bevorzugt einseitig geschlossen und der elektronische Treiber kann ist bzgl. Schwerkraft unten angeordnet sein und somit gleichzeitig in das Füllmaterial eingebettet werden. Alternativ kann die Lampe auch zuerst mit dem niedrigviskosen reinen Gießharz/Kleber gefüllt werden, ein leichtes Anhärten nachgeschaltet werden, damit das Gießharz/Kleber hochviskos wird, und abschließend die optischen Streupartikel eingefüllt werden, die an der hochviskosen Gießharz/Kleberbahn kleben bleiben.

Alternativ oder zusätzlich zu Gießharzen und/oder Polymerklebern können auch sogenannte Hotmelt-Klebstoffe zum Einsatz kommen, d.h. Klebstoffe, die zunächst in fester Form, z.B. als Pulver oder Granulat, vorliegen und erst bei Erhitzung flüssig werden.

Hierbei kann der Füllvorgang komplett mittels Feststoffen erfolgen (Hotmeltgranulat und Füllstoffe wie Glasperlen, Sand, Kalk oder Keramikpulver). Die Verbindung mit dem Glaskolben und/oder den elektronischen Bauteilen erfolgt durch anschließendes Erhitzen, wodurch der der Hotmelt-Klebstoff aufgeschmolzen wird.

Da Hotmelt-Klebstoffe und Polymermassen (Polymergießharz, Polymerkleber) teurer sind als die Füllstoffe, kann mittels eines 3-stufigen Verfahrens die Menge an Holtmelt-Klebstoff bzw. Polymermasse möglichst gering gehalten werden: 1. Einbringung der reinen Füllstoffe in den Treiberbereich der einseitig geschlossenen Lampe, 2. Einbringung des Hotmelt-Granulats auf das Füllstoffgranulat. 3. Aufschmelzen der Hotmelt-Versiegelungsschicht und Abdichten des Treiberbereiches.

Dies hat den weiteren Vorteil, dass das Aufschmelzen der Hotmelt-Versiegelungsschicht räumlich getrennt von den elektronischen Bauteilen erfolgt. Im Idealfall ist die Versiegelungsschicht lediglich mit dem temperaturbeständigem Lead-Frame-Metall, dem temperaturbeständigem Weichglas-Hüllkolben und dem temperaturstabilen Füllmaterial (Glaskugeln, Sand, etc.) in Kontakt.

Erfindungsgemäß weist der Leadframe einen oder mehrere Vorsprünge, insbesondere Tiefziehabschnitte, Prägungen, etc. auf. Die Vorsprünge befinden sich auf der Unterseite des Leadframes, d.h. auf der Oberfläche, auf der keine Halbleiterleuchtelemente angeordnet sind. Auf der Oberseite des Leadframes, d.h. auf der Oberfläche, auf der die Halbleiterleuchtelemente angeordnet sind, stellen sich die Vorsprünge dann als Vertiefungen dar. Im Bereich der Vorsprünge, d.h. im Wesentlichen um die Vorsprünge auf der Unterseite des Leadframes herum und/oder auf den Vorsprüngen, ist der Leadframe mit einem Kleber versehen, mit dem der Leadframe an der Innenseite des röhrenförmigen Kolbens befestigt ist.

Die Vorsprünge verringern den Abstand zwischen Leadframe und innerer Oberfläche des röhrenförmigen Kolbens, sodass beim Verkleben des Leadframes mit dem röhrenförmigen Kolben an diesen Stellen eine geringere Menge an Klebstoff benötigt wird.

Der Abstand zwischen zwei Halbleiterleuchtelementen beträgt üblicherweise etwa 17 mm. Um eine ausreichende Anzahl an Klebepunkten zu erreichen, kann der Abstand zwischen zwei Vertiefungen dem 2-, 3-, 4- oder 5-fachen Abstand der Halbleiterleuchtelemente entsprechen, insbesondere etwa 34 mm, 51 mm, 68 mm oder 85 mm betragen. Auch andere Abstände sind möglich. Die Vorsprünge können auch ungleichmäßig entlang der Light Engine verteilt sein.

Alternativ, in einer nicht beanspruchten Ausführungsform, oder zusätzlich kann der Leadframe mittels Halteklammern, die an der Innenseite des röhrenförmigen Kolbens befestigt sind, befestigt werden. Solche Halteklammern sind aus der internationalen Patentanmeldung WO 2011/064305 A1 bekannt.

In einer Ausführungsform weist der Leadframe umgebogene Abschnitte auf, die durch einseitiges Ausstanzen und umbiegen entstehen können. Diese können die Kühlfläche für stark thermisch belastete elektronische Bauteile vergrößern.

Weiterhin kann der Leadframe mittels Laserschweißen an der Innenseite des röhrenförmigen Kolbens befestigt werden. Dabei wird der Leadframe an Stellen, an denen der Leadframe an der Innenseite des Kolbens anliegt punktweise mittels eines Lasers durch das Glas des Kolbens erhitzt. Die Wärme wird auf das Glas übertragen und dieses geschmolzen. Dadurch wird der Leadframe mit dem Glas verschmolzen.

Vorzugsweise ist das Material des Leadframes so gewählt, dass es - neben der erforderlichen elektrischen Leitfähigkeit und Lötbarkeit - einen ähnlichen thermischen Ausdehnungskoeffizienten wie das Glas des röhrenförmigen Kolbens aufweist. Beispielsweise kann der röhrenförmige Kolben aus einem üblichen Kalk-Natron-Glas mit einem thermischen Ausdehnungskoeffizienten von etwa 9,8 ppm/K und der Leadframe aus DC01-Stahl mit einem thermischen Ausdehnungskoeffizienten von etwa 10,5 ppm/K bestehen. Der Unterschied von 0,7 ppm/K entspricht bei einem Leuchtmittel mit einer Länge von 1,5 m bei einer Temperaturdifferent von 100 K (z.B. -20 °C bis 80 °C) einem Unterschied in der Längenausdehnung von etwa 0,1 mm. Ein solcher Unterschied kann problemlos von den genannten Befestigungsmethoden ausgeglichen werden. Insbesondere wird dadurch das direkte Kleben des Leadframes auf die Innenseite des röhrenförmigen Kolbens ermöglicht.

In einer Ausführungsform weist der elektronische Treiber eine Leiterplatte auf, auf der mindestens eines der elektronischen Bauteile angeordnet ist. Die elektronischen Bauteile des elektronischen Treibers können also alle auf der Leiterplatte, alle auf dem Leadboard oder teilweise auf der Leiterplatte und teilweise auf dem Leadboard angeordnet sein. Die Leiterplatte kann vollständig innerhalb des röhrenförmigen Kolbens oder zumindest teilweise in einer Endkappe des Leuchtmittels angeordnet sein.

Die Leiterplatte kann mit dem Leadframe über mindestens ein elektrisch leitendes Verbindungselement verbunden sein.

Es können auch zwei Leiterplatten für elektronische Bauteile des elektronischen Treibers vorgesehen sein, wobei jede Leiterplatte vollständig innerhalb des röhrenförmigen Kolbens oder zumindest teilweise in einer Endkappe des Leuchtmittels angeordnet sein kann. Die elektronischen Bauteile des elektronischen Treibers können dann auf die beiden Leiterplatten verteilt werden. Entsprechend werden dann zwei elektrisch leitende Verbindungselemente zur Verbindung zwischen Leiterplatte und Leadframe vorgesehen.

Es kann auch vorgesehen sein, dass eine erste Leiterplatte vollständig innerhalb des (möglicherweise gasdicht verschlossenen) röhrenförmigen Kolbens angeordnet ist und eine zweite Leiterplatte außerhalb des röhrenförmigen Kolbens zumindest teilweise in einer Endkappe des Leuchtmittels angeordnet ist. Dadurch können elektronische Bauteile, die eine unerwünschte Ausgasung aufweisen, außerhalb des röhrenförmigen Kolbens angeordnet werden, während die anderen elektronischen Bauteile im Inneren des röhrenförmigen Kolbens angeordnet sind, wo sie vor Umwelteinflüssen geschützt sind.

In einer Ausführungsform weist der Leadframe einen umgebogenen Abschnitt auf, der als Verbindungselement dient. Dazu kann insbesondere eine der ausgestanzten oder ausgeschnittenen Metallflächen des Leadframes zumindest teilweise in die Form eines Verbindungselements gebogen werden. Das für den Leadframe verwendete Material kann Federeigenschaften aufweisen, die dafür sorgen, dass der umgebogene Teil des Leadframes gegen entsprechende Kontaktflächen auf den Leiterplatte drückt.

In einer Ausführungsform weist die Light Engine ferner ein elektrisch leitendes Mittel auf, insbesondere ein Kabel, das sich von einem ersten Ende des Leadframes oder einer am ersten Ende des Leadframes angeordneten Leiterplatte zu einem zweiten Ende des Leadframes oder einer am zweiten Ende des Leadframes angeordneten Leiterplatte erstreckt. Dadurch kann eine elektrische Verbindung zwischen den beiden Enden des Leadframes bzw. zwischen an beiden Enden angeordneten Abschnitten des elektronischen Treibers erreicht werden, ohne entsprechende Abschnitt im Leadframe dafür vorzusehen. Dies erlaubt es, den Leadframe möglichst schmal auszuführen.

In einer Ausführungsform weist die Light Engine einen oder mehrere Stabilisierungsabschnitte aus einem isolierenden Material aufweist, die lokal, vorzugsweise punkt- und/oder linienförmig, in Zwischenräume des Leadframes eingebracht sind, um Abschnitte des Leadframes aneinander zu befestigen und vorzugsweise voneinander zu beabstanden.

"Lokal" bedeutet in diesem Zusammenhang insbesondere, dass der Leadframe nicht vollständig oder zum großen Teil in ein Gehäuse oder einen Mantel, etwa aus Kunststoff, eingebettet ist. Die Stabilisierungsabschnitte zeichnen sich demzufolge dadurch aus, dass sie gezielt an Stellen des Leadframes vorgesehen sind, an denen eine Stabilisierung und ggf. Beabstandung erforderlich ist, um die mechanische und elektrische Funktionalität des LED-Moduls zu gewährleisten. Die Stabilisierungsabschnitte können insbesondere so in Zwischenräumen, etwa Spalten, vorgesehen sein, dass ein unbeabsichtigtes Zusammenbiegen und Kontaktieren elektrisch zu isolierender Abschnitte des Leadframes unterbunden wird.

Die Stabilisierungsabschnitte sind vorzugsweise aus Polymer und/oder Glas und/oder Keramik und/oder Kitt und/oder SMD-Bauteilen mit Isolationseigenschaft gefertigt. Unter SMD-Bauteilen mit Isolationseigenschaft sind umfasst: Widerstände mit einem extrem hohen Widerstand im Mega- oder Gigaohmbereich, Dioden in Sperrrichtung, Kondensatoren bei Gleichstromanwendungen oder ähnliches. Als vorteilhaftes Polymer hat sich Epoxidharzkleber erwiesen, dessen thermischer Ausdehnungskoeffizient in der gleichen Größenordnung liegt wie ein etwaiges Polymergehäuse von Halbleiterleuchtelementen wie LEDs und somit bei wechselnder Temperaturbeanspruchung keine thermischen Spannungen auf die Halbleiterleuchtelemente verursacht. Alternativ oder zusätzlich kommen auch andere Polymere in Frage, wie etwa Thermoplaste, beispielsweise PC, PMMA, PBT, Duroplaste oder Elastomere, wie beispielsweise Silikone.

Dadurch wird der Leadframe der Light Engine besonders gut stabilisiert, sodass er, auch nachdem die zunächst noch stabilisierenden Verbindungstege entfernt wurden, während der Montage im röhrenförmigen Kolben gut handhabbar ist.

Eine derartige Stabilisierung kann insbesondere dort von Vorteil sein, wo längere Abschnitte des Leadframes nebeneinander verlaufen, ohne dass sie mittels elektronischer Bauteile (wie Bauteile des elektronischen Treibers oder Kondensatoren zur Reduktion von elektromagnetischen Störabstrahlungen) miteinander verbunden sind.

Vorzugsweise weisen die beiden Oberflächen des Leadframes größtenteils keinen Kontakt mit Material der Stabilisierungsabschnitte auf. "Größtenteils" bedeutet, dass mehr als die Hälfte, vorzugsweise mehr als 80%, beider Oberflächen (einzeln betrachtet) nicht mit Stabilisierungsabschnitten in Kontakt stehen. Vorzugsweise sind beide Oberflächen (einzeln betrachtet) des Leadframes größtenteils (in dem oben definierten Sinne) unbedeckt, d.h. weisen zudem auch keinen Kontakt mit LEDs, SMD-Bauteilen, Lötstellen usw. auf. Dies verbessert insbesondere die Wärmeabfuhr über den Leadframe an das im röhrenförmigen Kolben befindliche Gas.

Aus den gleichen Gründen sind die einzelnen Stabilisierungsabschnitte vorzugsweise unterscheidbar, d.h. sie überlappen sich nicht zu einem Gebilde in der Größenordnung des Leadframes. Die Ausdehnung der einzelnen Stabilisierungsabschnitte entspricht demnach vorzugsweise nur einem kleinen Teil der Gesamtausdehnung des Leadframes. Insbesondere weist der Leadframe vorzugsweise elektrisch isolierende Zwischenräume, etwa Spalte oder Spaltabschnitte, auf, die nicht befüllt sind und den Leadframe somit in der Dickenrichtung vollständig durchdringen. Vorzugsweise entspricht die Ausdehnung der Stabilisierungsabschnitte im Wesentlichen der Größenordnung der zu überbrückenden Zwischenräume.

### Kurze Beschreibung der Figuren

Bevorzugte weitere Ausführungsformen werden durch die nachfolgende Beschreibung der Figuren näher erläutert. Dabei zeigen:
- Figur 1: eine Ausführungsform einer Röhrenlampe;
- Figur 2: eine schematische Darstellung der elektrischen Schaltung der LEDs in der Ausführungsform gemäß Figur 1;
- Figur 3: eine Ausführungsform der Verbindung zwischen Leiterplatte und Leadframe;
- Figur 4: schematisch eine Anordnung mehrerer Leadframes einer Ausführungsform während der Herstellung;
- Figur 5: schematisch eine Anordnung mehrerer Leadframes einer weiteren Ausführungsform während der Herstellung;
- Figur 6: schematisch eine Anordnung mehrerer Leadframes einer weiteren Ausführungsform während der Herstellung;
- Figur 7: schematisch eine Anordnung mehrerer Leadframes einer weiteren Ausführungsform während der Herstellung;
- Figur 8: schematisch eine Anordnung mehrerer Leadframes einer weiteren Ausführungsform während der Herstellung;
- Figur 9: schematisch eine Anordnung mehrerer Leadframes einer weiteren Ausführungsform während der Herstellung;
- Figur 10: eine schematische Darstellung der elektrischen Schaltung eines linearen Treibers für die LEDs;
- Figur 11: schematisch eine Anordnung mehrerer Leadframes einer weiteren Ausführungsform während der Herstellung;
- Figur 12: schematisch eine Seitenansicht eines Leadframes entsprechend Figur 11;
- Figur 13: schematisch einen Leadframe mit einem zusätzlichen Verbindungskabel;
- Figur 14: schematisch eine Anordnung mehrerer Leadframes einer weiteren Ausführungsform während der Herstellung;
- Figur 15: schematisch eine Anordnung mehrerer Leadframes einer weiteren Ausführungsform während der Herstellung;
- Figur 16: eine Ausführungsform eines Leuchtmittels mit einem Leadframe gemäß Figur 15;
- Figur 17: schematisch eine Ausführungsform eines ersten Endbereichs eines Leadframes;
- Figur 18: schematisch eine Ausführungsform eines zweiten Endbereichs eines Leadframes;
- Figur 19: schematisch den ersten Endbereich eines Leadframes aus Figur 17 mit elektronischen Bauteilen in einem Leuchtmittel;
- Figur 20: schematisch den ersten Endbereich eines Leadframes aus Figur 17 ohne elektronische Bauteile in einem Leuchtmittel.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente in den unterschiedlichen Figuren mit identischen Bezugszeichen versehen, und auf eine wiederholte Beschreibung dieser Elemente wird teilweise verzichtet, um Redundanzen zu vermeiden.

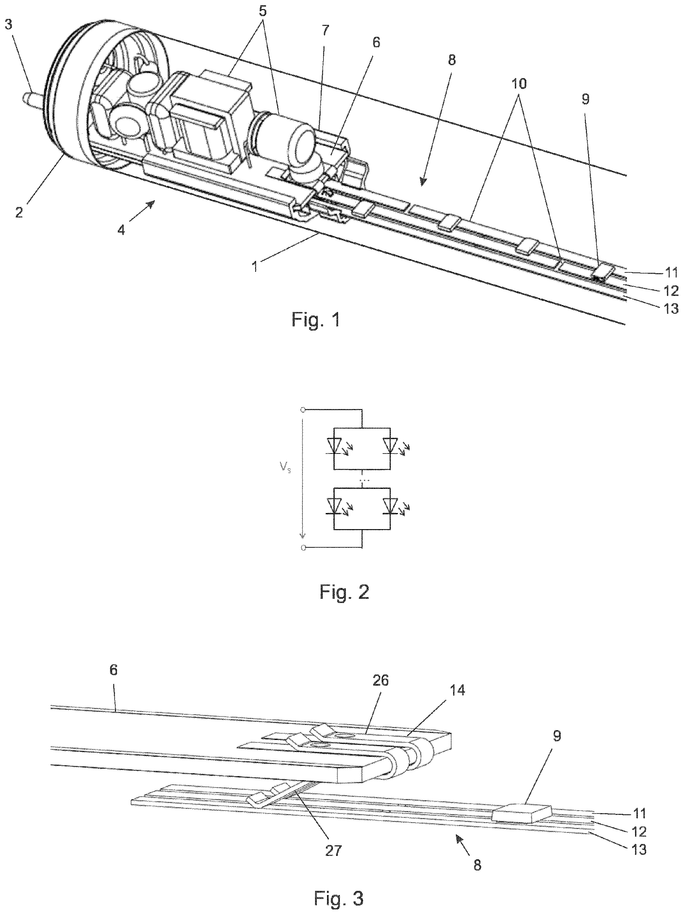

In Figur 1 ist eine Ausführungsform einer Röhrenlampe teilweise dargestellt. Die Röhrenlampe weist einen lichtdurchlässigen röhrenförmigen Kolben 1 auf, an dessen beiden Enden jeweils eine Endkappe 2 angeordnet ist. In der Endkappe sind zwei Anschlussstifte 3 befestigt, mit denen die Röhrenlampe in einer entsprechenden Fassung gehaltert und über die die Röhrenlampe mit elektrischer Energie versorgt werden kann.

Im Inneren der Endkappe 2 und sich von dort ins Innere des röhrenförmigen Kolbens 1 erstreckend befindet sich ein elektronischer Treiber 4, dessen elektronische Bauteile 5 auf einer Leiterplatte 6 angeordnet sind. Der Treiber 4 wird mittels einer auf der Innenseite des röhrenförmigen Kolbens 1 angeklebten Halteschiene 7 sicher im Inneren der Röhrenlampe gehalten.

Als Light Engine kommt ein Leadframe 8 zum Einsatz, auf dem mehrere Leuchtdioden (LEDs) 9 angeordnet sind. Der Leadframe 8 umfasst mehrere Abschnitte 10, die aus einem Metallblech (z.B. aus DC01-Stahl) ausgestanzt oder ausgeschnitten wurden. In der dargestellten Ausführungsform weist der Leadframe 8 im Wesentlichen drei parallele Bahnen auf, wobei die erste Bahn 11 (in der Abbildung als hintere Bahn gezeigt) und die zweite Bahn 12 (in der Abbildung als mittlere Bahn gezeigt) sich jeweils aus mehreren Abschnitten 10 zusammensetzen. Die dritte Bahn 13 (in der Abbildung als vordere Bahn gezeigt) hingegen ist über die Länge des Leadframes 8 durchgehend. Die Bezeichnungen "vordere", "mittlere" und "hintere" bezieht sich dabei auf die Darstellung in der Abbildung und werden im Folgenden synonym zu "erste", "zweite" und "dritte" Bahn verwendet. Die Abschnitte 10 der hinteren Bahn 11 und der mittleren Bahn 12 sind versetzt zueinander angeordnet, sodass diese jeweils über einen halben Abschnitt 10 überlappen. Zwischen dem rechten Bereich (in der Abbildung) eines Abschnitts 10 der hinteren Bahn 11 und dem linken Bereich (in der Abbildung) eines Abschnitt 10 der mittleren Bahn 12 sind zwei LEDs 9 parallel zueinander verbunden. Zwischen dem rechten Bereich (in der Abbildung) eines Abschnitts 10 der mittleren Bahn 12 und dem linken Bereich (in der Abbildung) eines Abschnitt 10 der hinteren Bahn 11 sind ebenfalls zwei LEDs 9 parallel zueinander verbunden, sodass die erstgenannte Gruppe von parallelen LEDs und die zweitgenannte Gruppe von parallelen LEDs in Reihe geschaltet sind. Dieses Muster setzt sich über die Länge des Leadframes 8 fort.

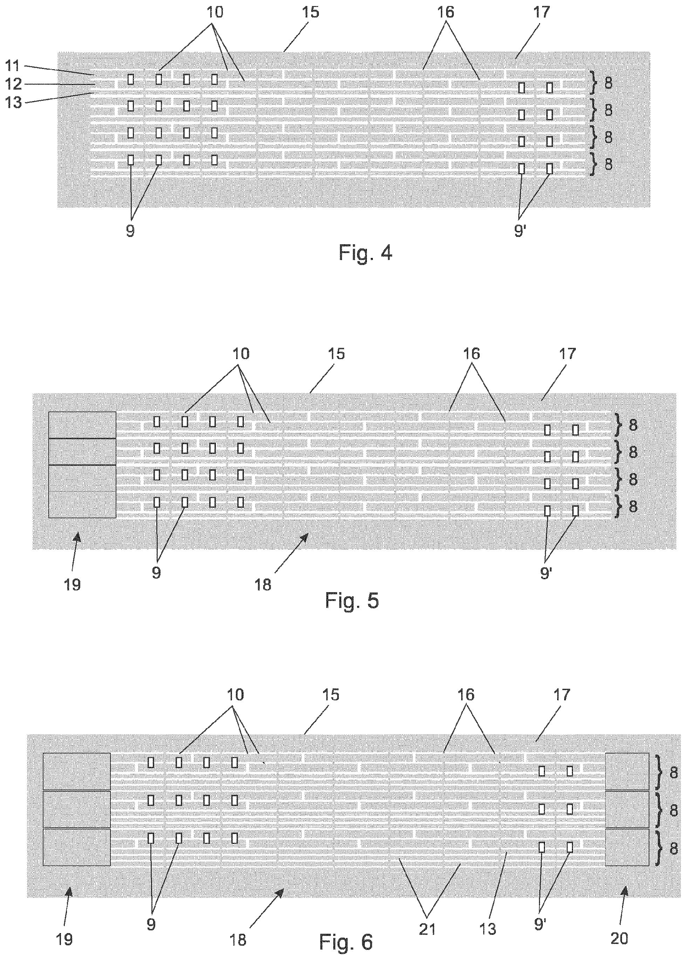

Der erste (linke) Abschnitt der hinteren Bahn 11 ist mit einem ersten Ausgangsanschluss des elektronischen Treibers 4 verbunden. Das letzte Paar mit zwei parallelen LEDs 9' (in Figur 1 nicht dargestellt, aber in Figur 4 zu sehen) ist mit dem rechten Abschnitt der mittleren Bahn 12 und mit der vorderen (durchgehenden) Bahn 13 verbunden. Dadurch wird die Verbindung zu einem zweiten Ausgangsanschluss des elektronischen Treibers 4 erreicht und der Stromkreis geschlossen. Anstelle von zwei LEDs kann für die Verbindung zwischen mittlerer Bahn 12 und vorderer Bahn 13 auch ein 0-Ohm-Widerstand oder ein anderes leitendes Element zum Einsatz kommen. Alternativ oder zusätzlich können zum Schließen des Stromkreises ein oder mehrere Verbindungsstege beibehalten werden, d.h. beim Trennen der einzelnen Abschnitte des Leadframes werden diese Verbindungsstege nicht durchtrennt.

Damit sind die LEDs als Reihenschaltung von parallel geschalteten Paaren von LEDs angeordnet, wie schematisch in Figur 2 gezeigt ist.

In Figur 3 ist eine Ausführungsform der Verbindung zwischen der Leiterplatte des elektronischen Treiber 4 und dem Leadframe 8 dargestellt. Zwei Kontaktclips 26 werden mit jeweils einem im Wesentlichen U-förmigen Kontaktbereich 14 auf die Leiterplatte 6 des Treibers 4 so aufgesteckt, dass die U-förmigen Kontaktbereiche 14 auf der Leiterplatte 6 entsprechend angeordnete Kontaktstellen, die die beiden Ausgangsanschlüsse des Treibers 4 darstellen, kontaktieren. Vom unteren Schenkel der U-förmigen Kontaktbereiche 14 erstrecken sich Verbindungsbereiche 27 nach unten, die entsprechende Abschnitte 10 des Leadframes 8 kontaktieren. Dadurch wird eine elektrische Verbindung zwischen der Leiterplatte des elektronischen Treiber 4 und dem Leadframe 8 hergestellt.

Alternativ hier kann das linke Ende (in der Abbildung) der vorderen Bahn 13 und des ersten (linken) Abschnitts der hinteren Bahn 11 sind so gebogen, dass zwei im Wesentlichen U-förmige Kontaktbereiche 14 entstehen, in die die Leiterplatte 6 des Treibers 4 eingesteckt wird. Die U-förmigen Kontaktbereiche 14 kontaktieren dann auf der Leiterplatte 6 entsprechend angeordnete Kontaktstellen, die die beiden Ausgangsanschlüsse des Treibers 4 darstellen. Dadurch übernehmen die entsprechenden Abschnitte 10 des Leadframes 8 die Funktion der Kontaktclips 26.

In Figur 4 ist schematisch eine Anordnung mehrerer Leadframes 8, wie sie in einer Ausführungsform eines Leuchtmittels nach Figur 1 oder in anderen Ausführungsformen verwendet werden können, während der Herstellung dargestellt. Die Leadframes 8 wurden aus einem Blech 15 ausgestanzt oder ausgeschnitten (z.B. mittels Laserschneiden) und sind noch über Verbindungsstege 16 mit einem Rahmen 17 und untereinander verbunden. In Figur 4 sind vier Leadframes 8 dargestellt, es kann aber auch eine andere Anzahl von Leadframes 8 aus einem Blech 15 hergestellt werden.

Jeder Leadframe 8 weist drei Bahnen auf, eine obere Bahn 11 (entsprechend der ersten Bahn oder hinteren Bahn in Figur 1), eine mittlere Bahn 12 (entsprechend der zweiten Bahn oder mittleren Bahn in Figur 1) und eine untere Bahn 13 (entsprechend der dritten Bahn oder vorderen Bahn in Figur 1). Die Bezeichnungen "obere", "mittlere" und "untere" bezieht sich dabei auf die Darstellung in der Abbildung und werden im Folgenden synonym zu "erste", "zweite" und "dritte" Bahn verwendet.

Die obere Bahn 11 und die mittlere Bahn 12 setzen sich jeweils aus mehreren Abschnitten 10 zusammen. Die untere Bahn 13 ist durchgehend über die Länge des Leadframes. Die Abschnitte 10 der oberen Bahn 11 und der mittleren Bahn 12 sind versetzt zueinander angeordnet, sodass diese jeweils über einen halben Abschnitt 10 überlappen. Zwischen dem rechten Bereich (in der Abbildung) eines Abschnitts 10 der oberen Bahn 11 und dem linken Bereich (in der Abbildung) eines Abschnitt 10 der mittleren Bahn 12 sind zwei LEDs 9 parallel zueinander verbunden. Zwischen dem rechten Bereich (in der Abbildung) eines Abschnitts 10 der mittleren Bahn 12 und dem linken Bereich (in der Abbildung) eines Abschnitt 10 der oberen Bahn 11 sind ebenfalls zwei LEDs 9 parallel zueinander verbunden, sodass die erstgenannte Gruppe von parallelen LEDs und die zweitgenannte Gruppe von parallelen LEDs in Reihe geschaltet sind. Dieses Muster setzt sich über die Länge des Leadframes 8 fort. Aus Gründen der Übersichtlichkeit sind nicht alle LEDs 9 dargestellt.

Das letzte Paar mit zwei parallelen LEDs 9' ist mit dem rechten Abschnitt der mittleren Bahn 12 und mit der unteren (durchgehenden) Bahn 13 verbunden. Anstelle von zwei LEDs kann für die Verbindung zwischen mittlerer Bahn 12 und unterer Bahn 13 auch ein 0-Ohm-Widerstand oder ein anderes leitendes Element zum Einsatz kommen. Alternativ oder zusätzlich können zum Schließen des Stromkreises ein oder mehrere Verbindungsstege 16 beibehalten werden, d.h. beim Trennen der einzelnen Abschnitte des Leadframes 8 werden diese Verbindungsstege 16 nicht durchtrennt.

Zur Stabilisierung des Leadframes 8 können Stabilisierungsabschnitte zwischen den Abschnitten 10 und/oder zwischen den Bahnen 11, 12, 13 des Leadframes 8 vorgesehen sein. Vorzugsweise wird insbesondere die durchgehende untere Bahn 13 mit der daneben liegenden mittleren Bahn 12 lokal durch Stabilisierungsabschnitte (isolierendes Material oder isolierende SMD-Komponenten) verbunden.

Wenn alle LEDs 9 auf dem Leadframe 8 angebracht und mit diesem verbunden sind, können die Verbindungsstege 8 durchtrennt werden und die Leadframes 8 vom Rahmen 17 und untereinander getrennt werden.

Die Breite der Leadframes 8 beträgt vorzugsweise etwa 7 mm. Damit steht für die LEDs 9 ausreichend Platz auf dem Leadframe 8 zur Verfügung ohne unnötig Material für den Leadframe 8 zu benötigen. Die Breite der oberen Bahn 11 und der mittleren Bahn 12 beträgt vorzugsweise etwa (2,0 ± 0,1) mm. Die Breite der unteren Bahn 13 beträgt vorzugsweise etwa (1,6 ± 0,1) mm. Die Breite der Stanzöffnungen zwischen den Bahnen beträgt vorzugsweise (0,7 ± 0,1) mm. Die Breite der Stanzöffnungen zwischen den Abschnitten 10 in einer Bahn beträgt vorzugsweise (1,0 ± 0,1) mm. Die Länge der Abschnitte 10 der oberen Bahn 11 und der mittleren Bahn 12 beträgt vorzugsweise etwa (67,6 ± 0,5) mm. Die Länge des Leadframes 8 beträgt vorzugsweise 17 Abschnitte 10, d.h. etwa 1166 mm. Damit bleibt bei einer Lampe mit eine Gesamtlänge von 1200 mm (auch 4-Fuß-Lampe genannt) noch Platz für einen elektronischen Treiber. Wenn ein Stanzwerkzeug, das kürzer ist als der Leadframe, mehrfach verwendet werden soll, kann der Leadframe auch zunächst mit einer Länge von 18 Abschnitten hergestellt werden und ein Abschnitt später entfernt werden. In der Abbildung sind aus Gründen der besseren Erkennbarkeit weniger Abschnitte dargestellt. Die oben genannten Abmessungen können auch bei den nachfolgenden Leadframes verwendet werden.

Bei vier LEDs pro Abschnitt ergeben sich somit 66 oder 68 LEDs, je nachdem, ob die Verbindung zwischen mittlerer Bahn 12 und unterer Bahn 13 durch zwei LEDs 9' oder durch einen 0-Ohm-Widerstand erfolgt. Bei einer Betriebsspannung von 3 V pro LED ergibt dies eine Gesamtbetriebsspannung von 198 V oder 204 V. Eine solche Spannung kann mit beispielsweise mit einem linearen Treiber erzeugt werden.

In der Ausführungsform gemäß Figur 4 hat der erste (in der Abbildung linke) Abschnitt der oberen Bahn 11 eine Länge, die 3/4 der Länge der weiteren Abschnitte 10 entspricht. Der letzte (in der Abbildung rechte) Abschnitt der oberen Bahn 11 hat ebenfalls eine Länge, die 3/4 der Länge der weiteren Abschnitte 10 entspricht. Der erste (in der Abbildung linke) Abschnitt der mittleren Bahn 12 hat eine Länge, die 1/4 der Länge der weiteren Abschnitte 10 entspricht. Entsprechend hat der letzte (in der Abbildung rechte) Abschnitt der mittleren Bahn 12 ebenfalls eine Länge, die 1/4 der Länge der weiteren Abschnitte 10 entspricht.

Die ersten (in der Abbildung links) und/oder letzten (in der Abbildung rechts) Abschnitte können aber auch länger ausgeführt werden, was die Verbindung zum Treiber vereinfachen kann, insbesondere wenn Endabschnitte des Leadframes zu Kontaktbereichen umgeformt werden (siehe Figur 3).

In Figur 5 ist schematisch eine Anordnung mehrerer Leadframes 8 in einer weiteren Ausführungsform während der Herstellung dargestellt. Jeder Leadframe 8 weist einen Mittelbereich 18 und einen Endbereich 19 auf.

Der Mittelbereich 18 der Leadframes 8 in Figur 5 entspricht den in Figur 4 dargestellten Leadframes und wird hier nicht noch einmal erläutert. Es können aber auch andere Gestaltungen des Leadframes im Mittelbereich 18 zum Einsatz kommen.

Der Endbereich 19 der Leadframes 8 ist für elektronische Bauteile 5 des Treibers 4 vorgesehen. Die genaue Aufteilung des Endbereichs 19 in Leadframe-Abschnitte hängt von der Ausführung des Treibers 4 ab und ist deshalb hier nicht im Detail dargestellt.

Die Breite der Leadframes 8 beträgt vorzugsweise etwa 7 mm. Damit steht für die LEDs 9 und die elektronischen Bauteile 5 des Treibers ausreichend Platz auf dem Leadframe 8 zur Verfügung ohne unnötig Material für den Leadframe 8 zu benötigen.

In Figur 6 ist schematisch eine Anordnung mehrerer Leadframes 8 in einer weiteren Ausführungsform während der Herstellung dargestellt. Jeder Leadframe 8 weist einen Mittelbereich 18 und zwei Endbereiche 19, 20 auf.

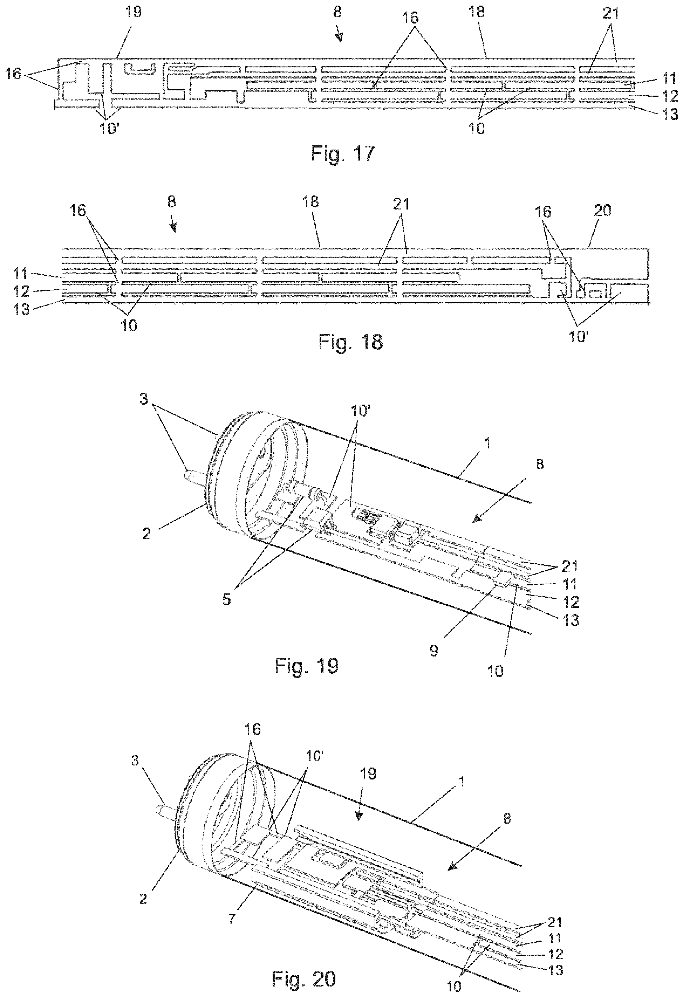

Die Endbereiche 19, 20 der Leadframes 8 sind für elektronische Bauteile 5 des Treibers 4 vorgesehen. Die genaue Aufteilung der Endbereiche 19, 20 in Leadframe-Abschnitte hängt von der Ausführung des Treibers 4 ab und ist deshalb hier nicht im Detail dargestellt. Eine Ausführungsform der Aufteilung der Endbereich des Leadframes 8 ist beispielhaft in den Figuren 17 bis 20 dargestellt. Die Aufteilung des Treibers 4 auf zwei Endbereiche 19, 20 erlaubt es, die Endbereiche 19, 20 jeweils kleiner auszuführen und so den nicht leuchtenden Bereich auf die beiden Enden des Leuchtmittels zu verteilen.

Der Mittelbereich 18 der Leadframes 8 in Figur 6 entspricht im Wesentlichen den in Figur 4 dargestellten Leadframes und wird hier insoweit nicht noch einmal erläutert. Es können aber auch andere Gestaltungen des Leadframes im Mittelbereich 18 zum Einsatz kommen. Zusätzlich zu dem aus Figur 4 übernommenen Abschnitt des Leadframes 8 (d.h. die drei oberen Bahnen 11, 12, 13) weist der Leadframe zwei weitere Bahnen 21 auf, die der Verbindung der beiden Teile des elektronischen Treiber 4 dienen.

Vorzugsweise werden die Bahnen 21 untereinander und/oder mit der daneben liegenden unteren Bahn 13 lokal durch Stabilisierungsabschnitte (isolierendes Material oder isolierende SMD-Komponenten) verbunden. Eine Stabilisierung kann insbesondere durch Kondensatoren erfolgen, was unerwünschte elektromagnetische Störausstrahlungen verhindern oder zumindest verringern kann.

Die Breite der Leadframes 8 beträgt vorzugsweise etwa 10 mm. Damit steht für die LEDs 9 und die elektronischen Bauteile 5 des Treibers ausreichend Platz auf dem Leadframe 8 zur Verfügung ohne unnötig Material für den Leadframe 8 zu benötigen. Die zusätzlichen Bahnen 21 bedingen eine breitere Ausführung des Leadframes 8 im Vergleich zu den vorherigen Ausführungsformen.

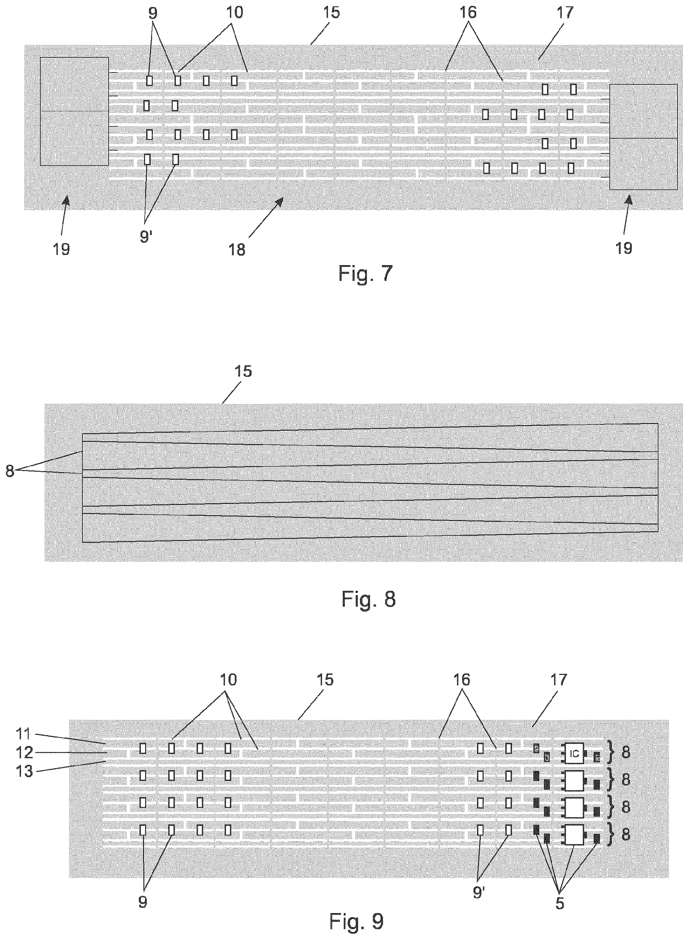

In Figur 7 ist schematisch eine Anordnung mehrerer Leadframes 8 in einer weiteren Ausführungsform während der Herstellung dargestellt. Jeder Leadframe 8 weist einen Mittelbereich 18 und einen Endbereich 19 auf.

Der Endbereich 19 der Leadframes 8 ist für elektronische Bauteile 5 des Treibers 4 vorgesehen. Die genaue Aufteilung des Endbereichs 19 in Leadframe-Abschnitte hängt von der Ausführung des Treibers 4 ab und ist deshalb hier nicht im Detail dargestellt.

Der Endbereich 19 ist doppelt so breit wie der Mittelbereich 18, sodass im Endbereich 19 mehr Platz für die elektronischen Bauteile 5 des Treibers 4 zur Verfügung steht. Die Breite des Mittelbereichs 18 der Leadframes 8 beträgt vorzugsweise etwa 7 mm, die Breite des Endbereichs damit etwa 14 mm. Damit steht für die LEDs 9 und die elektronischen Bauteile 5 des Treibers ausreichend Platz auf dem Leadframe 8 zur Verfügung ohne unnötig Material für den Leadframe 8 zu benötigen.

Die Leadframes 8, bei denen der Endbereich 19 auf der (in der Abbildung) linken Seite angeordnet ist, entsprechen (bis auf die Breite des Endbereichs 19) den Leadframes aus Figur 5. Die Leadframes 8, bei denen der Endbereich 19 auf der (in der Abbildung) rechten Seite angeordnet ist, sind im Vergleich hierzu um 180° gedreht.

In Figur 8 ist schematisch eine Anordnung mehrerer Leadframes 8 in einer weiteren Ausführungsform während der Herstellung dargestellt. Die Breite der Leadframes 8 verringert sich von einer ersten Breite an einem ersten Ende des Leadframes 8 zu einer zweiten Breite, die geringer ist als die erste Breite, an einem zweiten Ende des Leadframes 8. Die Breite am zweiten Ende beträgt vorzugsweise nicht mehr als etwa 7 mm, weiter bevorzugt nicht mehr als etwa 5 mm. Die Breite am ersten Ende beträgt vorzugsweise etwa 20 mm. Dadurch kann am breiteren Ende des Leadframes ausreichend Platz für den elektronischen Treiber zur Verfügungsgestellt werden.

Aus Gründen der Übersichtlichkeit ist die Aufteilung des Leadframes 8 in Abschnitte 10 hier nicht dargestellt.

In Figur 9 ist schematisch eine Anordnung mehrerer Leadframes 8 in einer weiteren Ausführungsform während der Herstellung dargestellt. Die Anordnung der Bahnen 11, 12, 13 und Abschnitte 10 des Leadframes 8 entspricht im Wesentlichen der aus Figur 4. Zusätzlich zu den LEDs 9 sind hier elektronische Bauteile 5 des Treibers 4 im Bereich der Light Engine unter Ausnutzung der Aufteilung der beiden oberen Bahnen 11, 12 in Abschnitte 10 angeordnet.

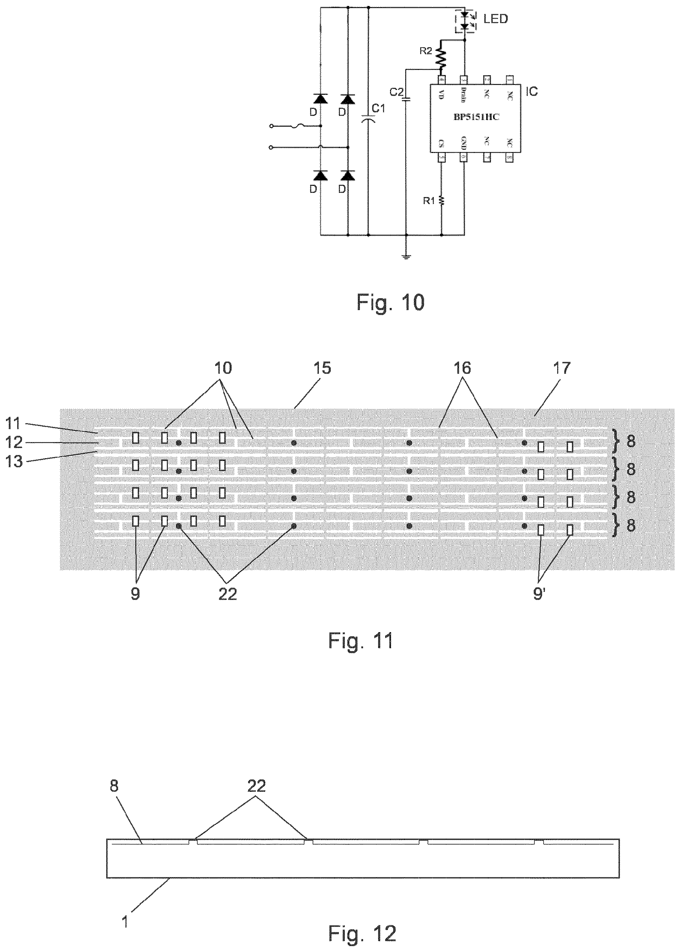

Als elektronischer Treiber 4 kann beispielsweise ein linearer Treiber zum Einsatz kommen, wie er schematisch in Figur 10 dargestellt ist. Der elektronische Treiber weist einen Gleichrichter aus vier Dioden D auf, an dessen Ausgang ein Glättungskondensator C1 vorgesehen ist. Ein Anschluss des Glättungskondensators C1 ist mit Masse verbunden. Für den linearen Treiber kommt ein integrierter Schaltkreis IC vom Typ BP5151HC zum Einsatz. Der Anschluss CS des integrierten Schaltkreises IC ist über einen Widerstand R1 mit Masse verbunden. Der Anschluss VD des integrierten Schaltkreises IC ist über einen Kondensator C2 mit Masse verbunden. Der Anschluss VD des integrierten Schaltkreises IC ist ferner über einen Widerstands R2 mit dem Kathodenende der in Reihe geschalteten LEDs verbunden. Der Anschluss Drain des integrierten Schaltkreises IC ist direkt mit dem Kathodenende der in Reihe geschalteten LEDs verbunden. Der Anschluss GND des integrierten Schaltkreises IC ist mit Masse verbunden. Der integrierte Schaltkreis IC vom Typ BP5151HC ist üblicherweise in der Bauform ESOP8 erhältlich, wie auch in Figur 10 dargestellt. Die vier Anschlüsse NC haben dabei keine Funktion. Wenn der integrierte Schaltkreis mit der gleichen Funktionalität in der Bauform SOT223 oder TO252 verwendet wird, so lässt er sich wie in Figur 9 gezeigt, zusammen mit den Widerständen R1 und R2 und dem Kondensator C2 direkt im Bereich der Light Engine auf dem Leadframe anordnen.

Der Gleichrichter und der Glättungskondensator C1 (in Figur 9 nicht dargestellt) können dann in einem oder zwei Endbereichen des Leadframes oder auf einer separaten Leiterplatte angeordnet werden.

In Figur 11 ist schematisch eine Anordnung mehrerer Leadframes 8 in einer weiteren Ausführungsform gemäß der Erfindung während der Herstellung dargestellt. Die Leadframes 8 entsprechen im Wesentlichen den Leadframes aus Figur 4.

Ungefähr in der Mitte eines jedes Abschnitts 10 der mittleren Bahn 12 ist eine Vertiefung 22 (von der Oberseite des Leadframes 8 gesehen) vorgesehen, die beispielsweise durch Prägen oder Tiefziehen erzeugt werden kann. Figur 12 zeigt schematisch eine Seitenansicht eines Leadframes 8 mit Vertiefungen 22 (wieder ohne LEDs) in einem röhrenförmigen Kolben 1. Die Vertiefungen 22 bzw. die daraus auf der anderen Seite des Leadframes 8 entstehenden Vorsprünge dienen dazu, den Abstand zwischen dem Leadframe 8 und der Innenseite des gewölbten rohrförmigen Kolbens 1 zu verringern. Dadurch entsteht ein schmaler Klebespalt, der die zu verwendende Klebermenge reduziert.

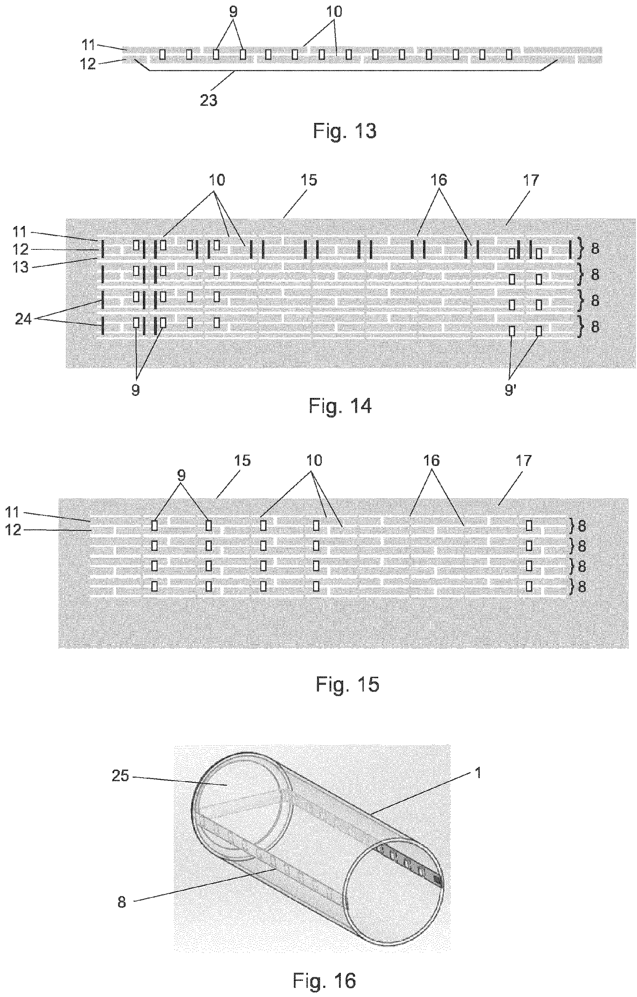

In Figur 13 ist schematisch ein Leadframe 8 in einer weiteren Ausführungsform dargestellt. Der Leadframe 8 entspricht im Wesentlichen den Leadframes aus Figur 4, weist allerdings keine untere Bahn 13 auf. Die elektrische Verbindung zwischen dem (in der Abbildung) rechten Ende des Leadframes 8 und einem (nicht dargestellten) Treiber am (in der Abbildung) linken Ende des Leadframes kann beispielsweise mit einem (schematisch angedeuteten) Kabel 23 erfolgen.

In Figur 14 ist schematisch eine Anordnung mehrerer Leadframes 8 in einer weiteren Ausführungsform während der Herstellung dargestellt. Die Leadframes 8 entsprechen im Wesentlichen den Leadframes aus Figur 4.

Die drei Bahnen 11, 12, 13 der Leadframes 8 sind durch Stabilisierungsabschnitte 24 aus isolierendem Material miteinander verbunden, wodurch die Stabilität der Leadframes 8 erhöht wird. Außer der gezeigten Anordnung der Stabilisierungsabschnitt 24 können auch andere Anordnungen zum Einsatz kommen. Aus Gründen der Übersichtlichkeit sind nicht alle Stabilisierungsabschnitte 24 dargestellt

In Figur 15 ist schematisch eine Anordnung mehrerer Leadframes 8 in einer weiteren Ausführungsform während der Herstellung dargestellt. Jeder Leadframe 8 weist zwei Bahnen auf, eine obere Bahn 11 und eine untere Bahn 12. Die Bezeichnungen "obere" und "untere" bezieht sich dabei auf die Darstellung in der Abbildung und werden im Folgenden synonym zu "erste" und "zweite" Bahn verwendet.

Die obere Bahn 11 und die untere Bahn 12 setzen sich jeweils aus mehreren Abschnitten 10 zusammen. Die Abschnitte 10 der oberen Bahn 11 und der unteren Bahn 12 sind versetzt zueinander angeordnet, sodass diese jeweils über einen halben Abschnitt 10 überlappen. Zwischen dem rechten Bereich (in der Abbildung) eines Abschnitts 10 der oberen Bahn 11 und dem linken Bereich (in der Abbildung) eines Abschnitt 10 der unteren Bahn 12 ist eine LED verbunden. Zwischen dem rechten Bereich (in der Abbildung) eines Abschnitts 10 der unteren Bahn 12 und dem linken Bereich (in der Abbildung) eines Abschnitt 10 der oberen Bahn 11 ist ebenfalls LED 9 verbunden, sodass die LEDs in Reihe geschaltet sind. Dieses Muster setzt sich über die Länge des Leadframes 8 fort. Aus Gründen der Übersichtlichkeit sind nicht alle LEDs 9 dargestellt. Der Leadframe 8 bewirkt hier also eine Reihenschaltung aller LEDs 9. Eine durchgehende Bahn zur Zurückführung der elektrischen Verbindung ist nicht vorgesehen.

In Figur 16 ist eine Ausführungsform eines Leuchtmittels teilweise dargestellt, bei dem der In Figur 15 gezeigte Leadframe 8 zum Einsatz kommt. Der Leadframe 8 ist an der Innenseite eines röhrenförmigen Kolbens 1 so angebracht, dass er von einem offenen Ende des Kolbens 1 zu einem geschlossenen Ende des Kolbens 1 verläuft, dort entlang der Stirnseite 25 verläuft und anschließend vom geschlossenen Ende des Kolbens 1 wieder zum offenen Ende des Kolbens 1 verläuft. Da beide Enden des Leadframes 8 somit am offenen Ende des Kolbens 1 liegen, können sie dort mit einem elektronischen Treiber (nicht dargestellt) verbunden werden, ohne dass eine durchgehende Bahn zur Zurückführung der elektrischen Verbindung erforderlich ist.

Entsprechend können auch die anderen oben dargestellten Leadframes jeweils ohne durchgehende dritte Bahn in einem derartigen Leuchtmittel verwendet werden.

Die in den Figuren 9 bis 15 dargestellten Leadframes 8 können jeweils auch mit einem oder zwei Endabschnitten 19, 20 für elektronische Bauteile 5 eines Treibers 4 versehen sein, wie es in den Figuren 5 bis 8 dargestellt ist.

In den Figuren 17 bis 20 ist exemplarisch dargestellt, wie der Endbereich bzw. die Endbereiche 19, 20 eines Leadframes 8 so in Abschnitte 10' aufgeteilt werden können, dass die elektronischen Bauteile 5 des Treibers 4 direkt auf dem Leadframe 8 angeordnet werden können.

Figur 17 zeigt links in der Abbildung schematisch einen ersten Endbereich 19 des Leadframes 8. Rechts in der Abbildung ist der Mittelbereich 18 des Leadframes mit drei jeweils aus mehreren Abschnitten 10 bestehenden Bahnen 11, 12, 13 (in der Abbildung unten) der Light-Engine dargestellt.

Figur 18 zeigt rechts in der Abbildung schematisch einen zweiten Endbereich 20 des Leadframes 8. Links in der Abbildung ist der Mittelbereich 18 des Leadframes mit drei jeweils aus mehreren Abschnitten 10 bestehenden Bahnen 11, 12, 13 (in der Abbildung unten) der Light-Engine dargestellt.

Die beiden oberen durchgehenden Bahnen 21 (in den Figuren 17 und 18 jeweils die beiden oberen Bahnen) dienen der Verbindung der beiden Treiberanschnitte, deren Bauteile 5 in den beiden Endbereichen 19, 20 des Leadframes 8 angeordnet sind.

Die Abschnitte 10, 10' des Leadframes 8 sind in den Figuren 17 und 18 noch mit Verbindungsstegen 16 miteinander verbunden. Diese können durchtrennt werden, nachdem die elektronischen Bauteile 5 des Treibers 4 auf dem Leadframe 8 befestigt sind.

In Figur 19 ist schematisch ein Leuchtmittel ausschnittsweise dargestellt mit einem Leadframe 8, auf dem die elektronischen Bauteile 5 des Treibers 4 direkt angeordnet sind. Die Anordnung aus Figur 19 ohne die elektronischen Bauteile 5 des Treibers 4 ist in Figur 20 dargestellt. Dafür zeigt Figur 20, wie der Leadframe 8 im Endbereich 19 in einer Halteschiene 7 gehalten werden kann. In Figur 20 sind auch die Verbindungsstege 16 dargestellt, die die Abschnitte 10, 10' des Leadframes 8 während der Herstellung verbinden.

Da üblicherweise die elektronischen Bauteile 5 des Treibers 4 auf dem Leadframe 8 angeordnet werden, bevor der Leadframe in das Leuchtmittel eingebaut wird, stellt die Figur 20 keinen Zustand dar, wie er während der Herstellung des Leuchtmittels üblicherweise vorkommt, sondern dient lediglich der Veranschaulichung.

Allgemein kann unter "ein", "eine" usw. eine Einzahl oder eine Mehrzahl verstanden werden, insbesondere im Sinne von "mindestens ein" oder "ein oder mehrere" usw., solange dies nicht explizit ausgeschlossen ist, z.B. durch den Ausdruck "genau ein" usw.

Auch kann eine Zahlenangabe genau die angegebene Zahl als auch einen üblichen Toleranzbereich umfassen, solange dies nicht explizit ausgeschlossen ist.

Soweit anwendbar, können alle einzelnen Merkmale, die in den Ausführungsbeispielen dargestellt sind, miteinander kombiniert und/oder ausgetauscht werden.

### Bezugszeichenliste

- 1: röhrenförmiger Kolben
- 2: Endkappe
- 3: Anschlussstift
- 4: elektronischer Treiber
- 5: elektronische Bauteile des elektronischen Treibers
- 6: Leiterplatte des elektronischen Treibers
- 7: Halteschiene
- 8: Leadframe
- 9: LED
- 9': LED
- 10: Abschnitt des Leadframes
- 10': Abschnitt des Leadframes
- 11: erste Bahn des Leadframes
- 12: zweite Bahn des Leadframes
- 13: dritte Bahn des Leadframes
- 14: U-förmige Kontaktbereiche
- 15: Blech
- 16: Verbindungsstege
- 17: Rahmen
- 18: Mittelbereich des Leadframes
- 19: erster Endbereich des Leadframes
- 20: zweiter Endbereich des Leadframes
- 21: weitere Bahnen des Leadframes
- 22: Vertiefungen
- 23: Kabel
- 24: Stabilisierungsabschnitt
- 25: Stirnseite
- 26: Kontaktclip
- 27: Verbindungsbereich des Kontaktclips

- D: Dioden des Gleichrichters
- C1: Glättungskondensator
- C2: Kondensator
- R1: Widerstand
- R2: Widerstand
- IC: integrierter Schaltkreis

## Patentansprüche

1. Leuchtmittel mit einem lichtdurchlässigen röhrenförmigen Kolben (1), mindestens einer an einem Ende des röhrenförmigen Kolbens (1) angeordneten Endkappe (2) und einer im röhrenförmigen Kolben (1) angeordneten Light Engine, wobei die Light Engine einen Leadframe (8) mit einer Unterseite und mit einer der Unterseite gegenüberliegenden Oberseite aufweist, auf der eine Mehrzahl von Halbleiterleuchtelementen (9) angeordnet ist, **dadurch gekennzeichnet, dass** der Leadframe mindestens zwei zueinander parallele Bahnen aufweist, wobei mindestens zwei der Bahnen mehrere Abschnitte aufweisen, wobei die Abschnitte einer ersten Bahn versetzt zu den Abschnitten einer zweiten Bahn angeordnet sind, sodass diese jeweils über einen halben Abschnitt überlappen, wobei der Lead-frame (8) einen oder mehrere Vorsprünge (22), insbesondere Tiefziehabschnitte, auf der Unterseite des Leadframes, d.h. auf der keine Halbleiterleuchtelemente angeordnet sind, aufweist, welche sich als Vertiefungen auf der Oberseite des Leadframes darstellen, und wobei der Leadframe (8) im Bereich der Vorsprünge (22) mit einem Kleber versehen ist, wobei der Leadframe (8) mittels des Klebers an der Innenseite des röhrenförmigen Kolbens (1) befestigt ist.

2. Leuchtmittel nach Anspruch 1, wobei der röhrenförmige Kolben (1) gasdicht verschlossen ist.

3. Leuchtmittel nach Anspruch 2, wobei der röhrenförmige Kolben (1) mit einem Füllgas gefüllt ist, wobei das Füllgas ein Gas mit hoher Wärmeleitfähigkeit aufweist.

4. Leuchtmittel nach einem der vorangegangenen Ansprüche, ferner aufweisend einen elektronischen Treiber (4) mit mehreren elektronischen Bauteilen (5), wobei mindestens eines der elektronischen Bauteile (5) innerhalb des röhrenförmigen Kolbens (1) angeordnet ist.

5. Leuchtmittel nach Anspruch 4, wobei mindestens eines der elektronischen Bauteile (5) auf dem Leadframe (8) angeordnet ist.

6. Leuchtmittel nach einem der Ansprüche 4-5, wobei der Leadframe (8) einen Mittelbereich (18), auf dem die Mehrzahl von Halbleiterleuchtelementen (9) angeordnet ist, und mindestens einen Endbereich (19, 20), auf dem mindestens eines der elektronischen Bauteile (5) des elektronischen Treibers (4) angeordnet ist, aufweist.

7. Leuchtmittel nach Anspruch 6, wobei die Breite des Leadframes (8) in mindestens einem Endbereich (19, 20) größer ist als die Breite des Leadframes (8) im Mittelbereich (18).

8. Leuchtmittel nach einem der Ansprüche 4-5, wobei die Breite des Leadframes (8) über dessen Länge variabel ist.

9. Leuchtmittel nach einem der Ansprüche 4-8, wobei der elektronische Treiber (4) ein linearer Treiber ist.

10. Leuchtmittel nach einem der vorangegangenen Ansprüche, wobei der röhrenförmige Kolben (1) zumindest teilweise mit einem Füllmaterial zumindest an der Innenseite des röhrenförmigen Kolbens (1) und/oder im Bereich von zumindest einer Endkappe (2) versehen ist.

11. Leuchtmittel nach einem der Ansprüche 4-10, wobei der elektronische Treiber (4) eine Leiterplatte (6) aufweist, auf der mindestens eines der elektronischen Bauteile (5) angeordnet ist, wobei die Leiterplatte (6) mit dem Leadframe (8) über mindestens ein elektrisch leitendes Verbindungselement verbunden ist.

12. Leuchtmittel nach Anspruch 11, wobei der Leadframe einen umgebogenen Abschnitt (14) aufweist, der als Verbindungselement dient.

13. Leuchtmittel nach einem der vorangegangenen Ansprüche, wobei die Light Engine ferner ein elektrisch leitendes Mittel, insbesondere ein Kabel, aufweist, das sich von einem ersten Ende des Leadframes (8) oder einer am ersten Ende des Leadframes (8) angeordneten Leiterplatte (6) zu einem zweiten Ende des Leadframes (8) oder einer am zweiten Ende des Leadframes (8) angeordneten Leiterplatte erstreckt.

14. Leuchtmittel nach einem der vorangegangenen Ansprüche, wobei die Light Engine einen oder mehrere Stabilisierungsabschnitte aus einem isolierenden Material aufweist, die lokal, vorzugsweise punkt- und/oder linienförmig, in Zwischenräume des Leadframes eingebracht sind, um Abschnitte des Leadframes aneinander zu befestigen und vorzugsweise voneinander zu beabstanden.

## Claims

1. Lighting means with a translucent tubular bulb (1), at least one end cap (2) arranged at one end of the tubular bulb (1) and a light engine arranged in the tubular bulb (1), wherein the light engine has a lead frame (8) with an underside and with an upper side opposite the underside, on which a plurality of semiconductor lighting elements (9) are arranged, **characterised in that** the lead frame has at least two tracks parallel to one another, at least two of the tracks having a plurality of sections, the sections of a first track being arranged offset relative to the sections of a second track, so that these each overlap by half a section, the lead frame (8) having one or more projections (22), in particular deep-drawing sections, on the underside of the lead frame, i.e. on which no semiconductor lighting elements (9) are arranged, which are in the form of depressions on the upper side of the lead frame, and wherein the lead frame (8) is provided with an adhesive in the region of the projections (22), wherein the lead frame (8) is attached to the inside of the tubular bulb (1) by means of the adhesive.

2. The lighting means according to claim 1, wherein the tubular bulb (1) is sealed in a gas-tight manner.

3. The lighting means according to claim 2, wherein the tubular bulb (1) is filled with a filling gas, wherein the filling gas has a gas with high thermal conductivity.

4. The lighting means according to one of the preceding claims, further comprising an electronic driver (4) with a plurality of electronic components (5), wherein at least one of the electronic components (5) is arranged within the tubular bulb (1).

5. The lighting means according to claim 4, wherein at least one of the electronic components (5) is arranged on the lead frame (8).

6. The lighting means according to any one of claims 4-5, wherein the lead frame (8) comprises a centre region (18) on which the plurality of semiconductor lighting elements (9) is arranged, and at least one end region (19, 20) on which at least one of the electronic components (5) of the electronic driver (4) is arranged.

7. The lighting means according to claim 6, wherein the width of the lead frame (8) in at least one end region (19, 20) is greater than the width of the lead frame (8) in the centre region (18).

8. The lighting means according to one of claims 4-5,
wherein the width of the lead frame (8) is variable over its length.

9. The lighting means according to any one of claims 4-8, wherein the electronic driver (4) is a linear driver.

10. The lighting means according to one of the preceding claims, wherein the tubular bulb (1) is at least partially provided with a filling material_at least on the inside of the tubular bulb (1) and/or in the region of at least one end cap (2).

11. The lighting means according to one of claims 4-10,
wherein the electronic driver (4) comprises a printed circuit board (6) on which at least one of the electronic components (5) is arranged, wherein the printed circuit board (6) is connected to the lead frame (8) via at least one electrically conductive connecting element.

12. The lighting means according to claim 11, wherein the lead frame has a bent-over section (14) which serves as a connecting element.

13. The lighting means according to one of the preceding claims, wherein the light engine further comprises an electrically conductive means, in particular a cable, which extends from a first end of the lead frame (8) or a printed circuit board (6) arranged at the first end of the lead frame (8) to a second end of the lead frame (8) or a printed circuit board arranged at the second end of the lead frame (8).

14. The lighting means according to one of the preceding claims, wherein the light engine comprises one or more stabilising sections made of an insulating material which are introduced locally, preferably in the form of points and/or lines, into intermediate spaces of the lead frame in order to fasten sections of the lead frame to one another and preferably to space them apart from one another.

## Revendications

1. Moyen d'éclairage comprenant une ampoule tubulaire transparente (1), au moins un capuchon d'extrémité (2) disposé à une extrémité de l'ampoule tubulaire (1) et un moteur d'éclairage disposé dans l'ampoule tubulaire (1), le moteur d'éclairage comprenant un leadframe (8) avec une face inférieure et avec une face supérieure opposée à la face inférieure, sur laquelle est disposée une pluralité d'éléments d'éclairage à semi-conducteurs (9), **caractérisé en ce que** le leadframe comprend au moins deux pistes parallèles l'une à l'autre, au moins deux des pistes comprennent plusieurs sections, les sections d'une première piste étant disposées de manière décalée par rapport aux sections d'une deuxième piste, de sorte que celles-ci se chevauchent chacune sur une demisection, le leadframe (8) présentant une ou plusieurs saillies (22), en particulier des sections embouties, sur la face inférieure du leadframe, c'est-à-dire sur laquelle aucun élément lumineux semi-conducteur n'est disposé, qui se présentent sous la forme de creux sur la face supérieure du leadframe, et le leadframe (8) étant pourvu d'un adhésif dans la zone des saillies (22), le leadframe (8) étant fixé au moyen de l'adhésif sur la face intérieure de l'ampoule tubulaire (1).

2. Moyen d'éclairage selon la revendication 1, dans lequel l'ampoule tubulaire (1) est fermée de manière étanche aux gaz.

3. Moyen d'éclairage selon la revendication 2, dans lequel l'ampoule tubulaire (1) est remplie d'un gaz de remplissage, le gaz de remplissage comprenant un gaz ayant une conductivité thermique élevée.

4. Moyen d'éclairage selon l'une quelconque des revendications précédentes, comprenant en outre un pilote électronique (4) comportant une pluralité de composants électroniques (5), dans lequel au moins de l'un des composants électroniques (5) est disposé à l'intérieur de l'ampoule tubulaire (1).

5. Moyen d'éclairage selon la revendication 4, dans lequel au moins l'un des composants électroniques (5) est disposé sur le leadframe (8).

6. Moyen d'éclairage selon l'une des revendications 4-5, dans lequel le leadframe (8) comprend une zone centrale (18) sur laquelle est disposée la pluralité d'éléments lumineux semi-conducteurs (9) et au moins une zone d'extrémité (19, 20) sur laquelle est disposé au moins un des composants électroniques (5) du pilote électronique (4).

7. Moyen d'éclairage selon la revendication 6, dans lequel la largeur du leadframe (8) dans au moins une zone d'extrémité (19, 20) est supérieure à la largeur du leadframe (8) dans la zone centrale (18).

8. Moyen d'éclairage selon l'une des revendications 4-5, dans lequel la largeur du leadframe (8) est variable sur sa longueur.

9. Moyen d'éclairage selon l'une quelconque des revendications 4-8, dans lequel le pilote électronique (4) est un pilote linéaire.

10. Moyen d'éclairage selon l'une des revendications précédentes, dans lequel l'ampoule tubulaire (1) est au moins partiellement pourvue d'un matériau de remplissage au moins sur le côté intérieur de l'ampoule tubulaire (1) et/ou dans la zone d'au moins un capuchon d'extrémité (2).

11. Moyen d'éclairage selon l'une des revendications 4-10, dans lequel le pilote électronique (4) comprend une carte de circuit imprimé (6) sur laquelle est disposé au moins l'un des composants électroniques (5), la carte de circuit imprimé (6) étant reliée à la grille de connexion (8) par au moins un élément de connexion électriquement conducteur.

12. Moyen d'éclairage selon la revendication 11, dans lequel le leadframe comprend une section repliée (14) qui sert d'élément de liaison.

13. Moyen d'éclairage selon l'une des revendications précédentes, dans lequel le moteur d'éclairage présente en outre un moyen électriquement conducteur, en particulier un câble, qui s'étend d'une première extrémité du leadframe (8) ou d'une carte de circuit imprimé (6) disposée à la première extrémité du leadframe (8) à une deuxième extrémité du leadframe (8) ou d'une carte de circuit imprimé disposée à la deuxième extrémité du leadframe (8).

14. Moyen d'éclairage selon l'une quelconque des revendications précédentes, dans lequel le moteur d'éclairage comprend une ou plusieurs sections de stabilisation en un matériau isolant, qui sont insérées localement, de préférence de manière ponctuelle et/ou linéaire, dans des interstices du leadframe, afin de fixer des sections du leadframe les unes aux autres et, de préférence, de les espacer les unes des autres.
